# EUROPEAN PATENT APPLICATION

(11) **EP 4 086 975 A1**
(43) Date of publication of application: **09.11.2022**
(21) Application number: 21172715.1
(22) Date of filing: 07.05.2021
(51) Int. Cl.: H01L 33/00, H01L 33/32, H01L 33/50, H01L 33/08

(54) **FLIP-CHIP LIGHT-EMITTING DIODE STRUCTURE CAPABLE OF EMITTING TRICHROMATIC SPECTRUM AND MANUFACTURING METHOD THEREOF**

(71) Applicant: Excellence Opto. Inc., Miaoli County 35053 (TW)
(72) Inventor: CHEN, Fu-Bang, 35053 Hsinchu (TW); LAI, Chun-Ming, 35053 Hsinchu (TW); TSAI, Tzeng-Guang, 35053 Hsinchu (TW); HUANG, Kuo-Hsin, 35053 Hsinchu (TW)
(74) Representative: 2K Patentanwälte Blasberg Kewitz & Reichel

(57) **Abstract**

A flip-chip light-emitting diode structure capable of emitting trichromatic spectrum and a manufacturing method thereof, including a blue-green light layer with a light-stimulated green light-emitting structure (20) and an electron-stimulated blue light-emitting structure (10), a bonding layer and a red light layer with a light-stimulated red light-emitting structure (30). The manufacturing method uses a sapphire bonding layer (42) as the bonding layer, and forming the blue-green light layer and the red light layer by growing epitaxy on two sides of the sapphire bonding layer; or, after growing the blue-green light layer and the red light layer by epitaxy respectively, uses the bonding layer to connect. Accordingly, an externally applied voltage stimulates the electron-stimulated blue light-emitting structure (10) to generate a blue light, the blue light stimulates the light-stimulated green light-emitting structure (20) to generate a green light, and the blue and green lights stimulate the light-stimulated red light-emitting structure (30) to generate a red light.

## Description

### FIELD OF THE INVENTION

The present invention relates to a liquid crystal display backlight, and more particularly relates to a light-emitting diode structure and a manufacturing method of a liquid crystal display backlight with trichromatic spectrum.

### BACKGROUND OF THE INVENTION

The light-emitting principle of the thin-film transistor liquid crystal display (TFT-LCD) allows a backlight to pass through a trichromatic color-filter, and the TFT-LCD controls the light transmission rate of each of the three primary colors to achieve a mixed light pixel to display various colors. White LED is currently commonly used for color-filter backlight, which uses blue LED chips to generate blue light, and then green phosphor and red phosphor are coated on the surface of the LED or green phosphor and red phosphor are existed as a fluorescent thin-film on the LED externally, and then blue light is used to stimulate the green phosphor and the red phosphor to mix colors to form white light.

For example, the U.S. Patent No. US 9,214,601 B1 provides a structure that uses electron-stimulated light to generate purple light with 400nm wavelength, then uses light-stimulated light to generate blue light and green light, and then uses red luminescent substances and light-stimulated red phosphorescent substances to emit red light to be capable of generating white light with high color rendering.

All the above-mentioned backlights use phosphor, however, phosphor generally has the problems of wide spectrum with low color purity, low color scale, and poor color rendering, and poor reliability for easily decay and aging.

In order to improve the problem of excessively wide spectrum and poor reliability of phosphor, three red (R), green (G), and blue (B) LEDs are also used as a backlight source, because the blue and green light LEDs are nitride materials (AlGaInN), while the red light LED is a quaternary material of phosphides and arsenides (AlGaInP, AlGaAs). The use of three LEDs (R, G, B) can obtain a narrower spectral width, which is beneficial to color saturation of the display; but the disadvantages are higher costs (requiring three LED chips) and requiring two driving voltages (the driving voltage of quaternary material of red light is lower at 2V, and the driving voltage of nitride materials of blue light and green light is higher at 3V). In addition, because three LED chips need to be arranged side by side in spatial configuration, they cannot be mixed to emit light on a same tiny plane at the same time. The circuit of three LED chips is more complicated, bulky, and costly, and three LED chips have a higher failure probability than one LED chip.

In addition, PCT Publication Patent NO. WO 00/76005 A1 provides a blue light LED with a primary structure of nitride AlGaInN compound semiconductor. When electric current passes through, the blue active layer as a first active region is electrically stimulated to emit blue light; and the secondary active region is a quaternary compound (AlGaInP phosphide) semiconductor structure, which is the yellow active layer, the primary structure is used to emit high-energy blue light as a primary source, and to stimulate the yellow active layer of the secondary source to generate yellow light, and the yellow light and the penetrating blue light are mixed to form white light.

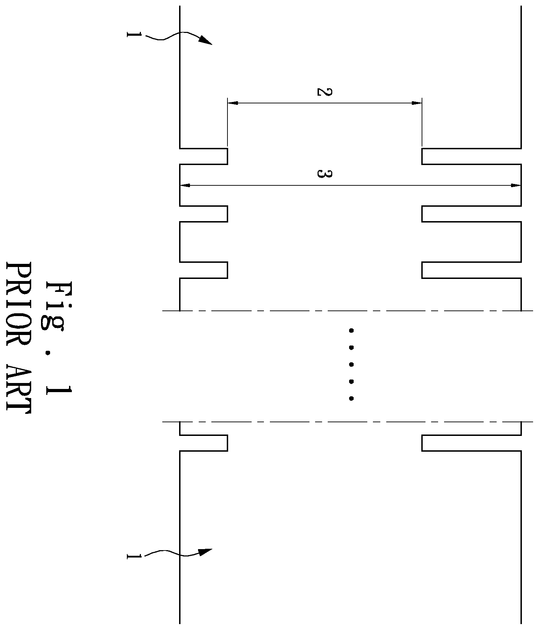

Please refer to FIG. 1 for an energy band diagram of a light-stimulated red light-emitting structure of quaternary epitaxy, which is a multiple quantum well comprising a confinement layer 1 on both sides, a plurality of potential energy wells 2 and a plurality of potential energy barriers 3. Since the quaternary material AlGaInP needs to be grown on a lattice-matched GaAs wafer, while a highest energy gap material composition of the confinement layer 1 and the potential energy barrier 3 is Al_{0.5}In_{0.5}P with an energy gap (Eg) of approximately 2.5eV, this material will absorb wavelengths below 492nm, and the energy of blue light 460 nm = 2.7eV. Thus, the potential energy barriers 3 and the confinement layer 1 of the quaternary compound semiconductor structure (AlGaInP phosphide) absorb a large amount of blue light to cause non-luminescent loss. Therefore, the luminous efficiency of the quaternary epitaxial light-stimulated red light-emitting structure is low and has no commercial value.

### SUMMARY OF THE INVENTION

A main object of the present invention is to provide a flip-chip light-emitting diode structure capable of emitting trichromatic spectrum that can be manufactured and operated efficiently and reliably, and to provide a corresponding manufacturing method thereof.

These problems are solved by a flip-chip light-emitting diode structure as claimed by claim 1 and by a method of manufacturing a flip-chip light-emitting diode structure as claimed by claim 7 and 9, respectively. Further advantageous embodiments are the subject-matter of the dependent claims.

A flip-chip light-emitting diode structure according to the present invention if configured to meet the requirements for conditions of high temperature, low temperature, and long-term vibration particularly in the automotive environment.

The present invention discloses a flip-chip light-emitting diode structure capable of emitting trichromatic spectrum, which comprises a blue-green light layer, a red light layer and a bonding layer, wherein the blue-green light layer includes an electron-stimulated blue light-emitting structure grown with nitride epitaxy, and a light-stimulated green light-emitting structure grown with nitride epitaxy, and the red light layer includes a light-stimulated red light-emitting structure grown with nitride epitaxy. The light-stimulated green light-emitting structure is disposed on the electron-stimulated blue light-emitting structure, the bonding layer is located between the light-stimulated red light-emitting structure and the light-stimulated green light-emitting structure, and the bonding layer bonds and fixes the light-stimulated red light-emitting structure and the light-stimulated green light-emitting structure. In addition, the electron-stimulated blue light-emitting structure is stimulated by an externally applied voltage to generate a blue light, the blue light stimulates the light-stimulated green light-emitting structure to generate a green light, and the blue light and the green light stimulate the light-stimulated red light-emitting structure to generate a red light.

Steps of one embodiment of the manufacturing method disclosed by the present invention comprise: preparing a sapphire bonding layer for growing epitaxy on two sides, using the sapphire bonding layer as the bonding layer, sequentially forming a first confinement layer, a green active layer and a second confinement layer of the light-stimulated green light-emitting structure, and an N-type semiconductor layer, a blue active layer and a P-type semiconductor layer of the electron-stimulated blue light-emitting structure on one side of the sapphire bonding layer; and sequentially forming a first confinement layer, a red active layer and a second confinement layer of the light-stimulated red light-emitting structure on the other side of the sapphire bonding layer.

Steps of another embodiment of the manufacturing method disclosed by the present invention comprise: sequentially forming the first confinement layer, the green active layer and the second confinement layer of the light-stimulated green light-emitting structure, and the N-type semiconductor layer, the blue active layer and the P-type semiconductor layer of the electron-stimulated blue light-emitting structure on one side of a sapphire wafer; and then sequentially forming the second confinement layer, the red active layer and the first confinement layer of the light-stimulated red light-emitting structure on a wafer for growing nitrides; connecting (bonding or binding) and fixing the first confinement layer of the light-stimulated red light-emitting structure and the sapphire wafer with the bonding layer; and thinning or removing the wafer to reduce light absorption of the wafer.

Accordingly, the flip-chip light-emitting diode structure capable of emitting trichromatic spectrum with green light, blue light and red light stimulates the electron-stimulated blue light-emitting structure to generate the blue light with the externally applied voltage, and then stimulates the light-stimulated green light-emitting structure to generate the green light with the blue light, and then stimulates the light-stimulated red light-emitting structure to generate the red light with the blue light and the green light. At this time, the blue light and green light that are not absorbed will penetrate therethrough and mix with the red light to form a trichromatic spectrum. The flip-chip light-emitting diode structure of the present invention is entirely composed of solid-state semiconductor materials without using phosphor, which includes characteristics of the trichromatic spectrum with high reliability and narrower half-height width, single blue light circuit, and uniform light emission on a same plane, thereby meeting the requirements for conditions of high temperature, low temperature, and long-term vibration in the automotive environment.

### BRIEF DESCRIPTION OF THE DRAWINGS

FIG. 1 is an energy band diagram of a conventional light-stimulated red light-emitting structure of quaternary epitaxy;
FIG. 2 is a cross-sectional structural view of a first embodiment of the present invention;
FIG. 3 is a schematic diagram of luminous intensities of a green active layer with different thicknesses of the present invention;
FIG. 4 is a schematic diagram of luminous intensities of three primary colors of the present invention;
FIG. 5 is a cross-sectional structural view of a second embodiment of the present invention;
FIG. 6 is a first cross-sectional structural view of a semi-finished product according to the second embodiment of the present invention;
FIG. 7 is a second cross-sectional structural view of a semi-finished product according to the second embodiment of the present invention; and
FIG. 8 is a third cross-sectional structural view of a semi-finished product according to the second embodiment of the present invention.

### DETAILED DESCRIPTION OF THE PREFERRED EMBODIMENTS

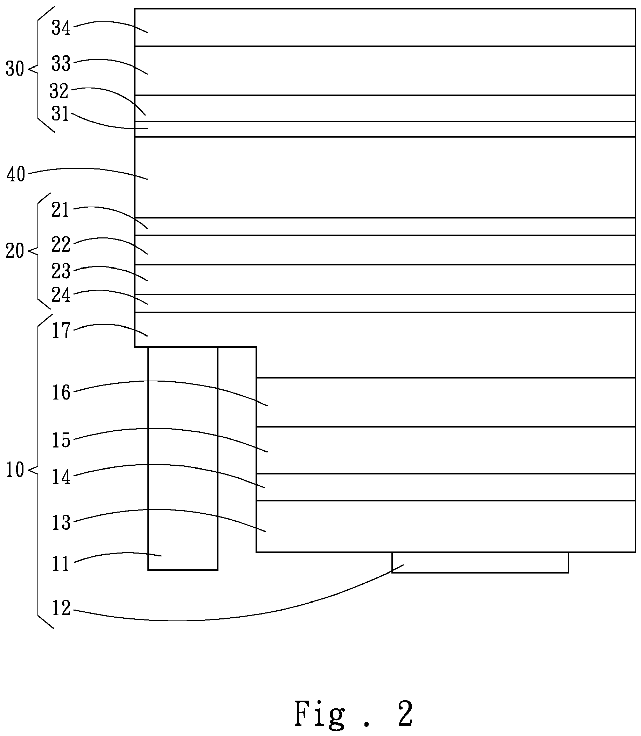

The detailed description and technical contents of the present invention will now be described with reference to the drawings as follows. Please refer to FIG. 2 for a first embodiment of the present invention. The present invention provides a flip-chip light-emitting diode structure capable of emitting trichromatic spectrum, which includes an electron-stimulated blue light-emitting structure 10 grown with nitride epitaxy, a light-stimulated green light-emitting structure 20 grown with nitride epitaxy, a light-stimulated red light-emitting structure 30 grown with nitride epitaxy, and a sapphire bonding layer 40. The electron-stimulated blue light-emitting structure 10 and the light-stimulated green light-emitting structure 20 are used as a blue-green epitaxial structure of a blue-green light layer; and the blue-green light layer generates a blue light with a wavelength range from 450nm to 465nm and a green light with a wavelength range from 520nm to 545nm. The light-stimulated red light-emitting structure 30 is used as a red epitaxial structure of a red light layer; and the red light layer generates a red light with a wavelength range from 620nm to 645nm.

The electron-stimulated blue light-emitting structure 10 is selectively made of aluminum indium gallium nitrides (AlGaInN). The electron-stimulated blue light-emitting structure 10 includes an N-type electrode 11 and a P-type electrode 12 located on a same plane. A metal layer 13, a reflective layer 14, a P-type semiconductor layer 15, a blue active layer 16 and an N-type semiconductor layer 17 are sequentially disposed on the P-type electrode 12, and the N-type semiconductor layer 17 is connected to the N-type electrode 11. The P-type semiconductor layer 15, the blue active layer 16 and the N-type semiconductor layer 17 are primary light-emitting structures of the electron-stimulated blue light-emitting structure 10, which are stimulated by an externally applied voltage to generate the blue light. The N-type electrode 11, the P-type electrode 12, the metal layer 13 and the reflective layer 14 are flip-chip electrodes for supplying the externally applied voltage and light reflection structures for extracting the blue light.

The light-stimulated green light-emitting structure 20 is selectively made of aluminum indium gallium nitrides (AlGaInN), and the light-stimulated green light-emitting structure 20 is disposed on the electron-stimulated blue light-emitting structure 10. The light-stimulated green light-emitting structure 20 includes a buffer layer 21, a first confinement layer 22, a green active layer 23 and a second confinement layer 24 stacked in sequence. The N-type semiconductor layer 17 is formed at the second confinement layer 24. The first confinement layer 22, the green active layer 23 and the second confinement layer 24 are primary light-emitting structures of the light-stimulated green light-emitting structure 20, which are stimulated by the blue light to generate the green light.

The light-stimulated red light-emitting structure 30 is selectively made of aluminum indium gallium nitrides (AlGaInN), the light-stimulated red light-emitting structure 30 includes a buffer layer 31, a first confinement layer 32, a red active layer 33 and a second confinement layer 34 stacked in sequence. The first confinement layer 32, the red active layer 33 and the second confinement layer 34 are primary light-emitting structures of the light-stimulated red light-emitting structure 30, which are stimulated by the blue light and the green light to generate the red light. Since the light-stimulated red light-emitting structure 30, specifically the red active layer 33, of the present invention is selectively made of aluminum indium gallium nitrides (AlGaInN). The light-stimulated red light-emitting structure 30 is a multiple quantum well composed of the first confinement layer 32, the red active layer 33 and the second confinement layer 34. The red active layer 33 includes a plurality of pairs of multiple quantum wells composed of potential energy wells and potential energy barriers. An energy gap of the potential energy well of the red active layer 33 is approximately Eg=1.95 eV; an energy gap of the potential energy barrier of each of the first confinement layer 32, the second confinement layer 34 and the red active layer 33 is approximately Eg=3.42 eV; and an energy gap of blue light in 460nm is approximately Eg=2.7eV. Obviously, the potential energy barriers of the first confinement layer 32, the second confinement layer 34 and the red active layer 33 will not absorb blue light, and only the potential energy well of the red active layer 33 will absorb blue light to be stimulated to generate the red light. Thus, non-luminescent loss can be reduced, and luminous efficiency can be effectively increased.

The sapphire bonding layer 40 is located between the light-stimulated red light-emitting structure 30 and the light-stimulated green light-emitting structure 20 to bond and fix the light-stimulated red light-emitting structure 30 and the light-stimulated green light-emitting structure 20. In this embodiment, the sapphire bonding layer 40 is used as a bonding layer, the sapphire bonding layer 40 is a sapphire wafer, and the light-stimulated green light-emitting structure 20 and the light-stimulated red light-emitting structure 30 are respectively formed on two sides of the sapphire bonding layer 40. In practice, the two sides of the sapphire bonding layer 40 are respectively formed with the buffer layer 21 of the light-stimulated green light-emitting structure 20 and the buffer layer 31 of the light-stimulated red light-emitting structure 30. That is, the sapphire bonding layer 40 bonds and fixes the buffer layer 21 of the blue-green epitaxial structure and the buffer layer 31 of the red epitaxial structure.

Further, the electron-stimulated blue light-emitting structure 10 is stimulated by the externally applied voltage to generate the blue light, and the blue light stimulates the light-stimulated green light-emitting structure 20 to generate the green light, and further the blue light and the green light stimulate the light-stimulated red light-emitting structure 30 to generate the red light, wherein the blue light and green light, that are not absorbed, will penetrate therethrough and mix with the red light to form a trichromatic spectrum.

Steps of a manufacturing method of an embodiment are described as follows. First, the sapphire bonding layer 40 capable of growing epitaxy on the two sides is prepared, and the sapphire bonding layer 40 is used as the bonding layer. Next, the light-stimulated green light-emitting structure 20 and the electron-stimulated blue light-emitting structure 10 are sequentially formed on one side of the sapphire bonding layer 40. In more detail, the buffer layer 21, the first confinement layer 22, the green active layer 23 and the second confinement layer 24 are sequentially formed on one side of the sapphire bonding layer 40, and then the N-type semiconductor layer 17, the blue active layer 16 and the P-type semiconductor layer 15 are formed thereon in sequence. Last, the reflective layer 14, the metal layer 13, the P-type electrode 12 and the N-type electrode 11 are subsequently formed thereon to complete the electron-stimulated blue light-emitting structure 10 in the following process.

In addition, the steps of the manufacturing method of this embodiment further include a step of forming the light-stimulated red light-emitting structure 30 on the other side of the sapphire bonding layer 40. That is, the buffer layer 31, the first confinement layer 32, the red active layer 33 and the second confinement layer 34 are sequentially formed.

In the first embodiment, the first confinement layer 22 is undoped GaN (U-GaN) with a thickness from about 1 µm to 3µm. The green active layer 23 is a multiple quantum well structure, which quantity of quantum wells is 20-50 pairs, the potential energy well composition is In_{0.26}Ga_{0.74}N with a thickness from about 20 angstroms (Å) to 40 Å, and the potential energy barrier is GaN with a thickness from about 50 Å to about 150 Å. The second confinement layer 24 is undoped GaN (U-GaN) with a thickness from about 1 µm to 3µm. The N-type semiconductor layer 17 is with a thickness from 2um to 4um, and a material of the N-type semiconductor layer 17 is N-GaN doped with Si. The blue active layer 16 is a multiple quantum well structure, which quantity of multiple quantum wells is 12 pairs to 25 pairs, and the potential energy well composition is In_{0.17}Ga_{0.83}N with a thickness from about 20 Å to 40 Å, and the potential energy barrier composition is GaN with a thickness from about 50 Å to about 150 Å. The P-type semiconductor layer 15 is with a thickness from 0.2 µm to 0.6 µm, and a material of the P-type semiconductor layer 15 is P-GaN doped with Mg.

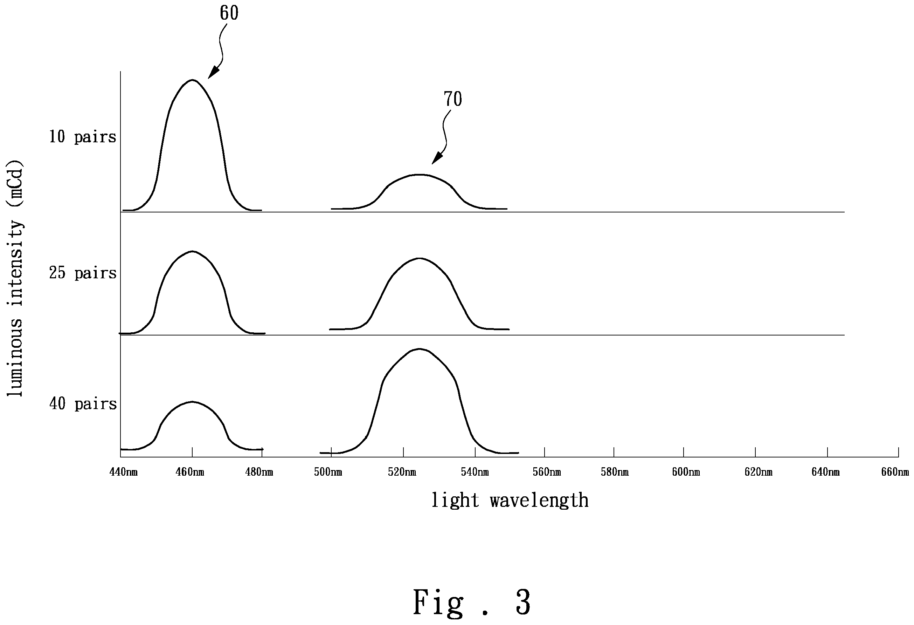

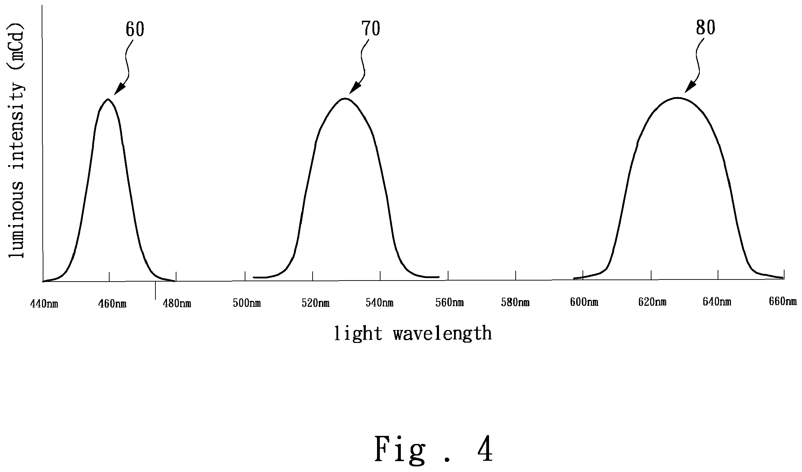

Please refer to FIG. 2, FIG. 3 and FIG. 4 together. In manufacturing, the blue light generated by the electron-stimulated blue light-emitting structure 10 stimulated by the externally applied voltage is used as a main light source, and then a ratio of the blue light converted into the green light is determined by controlling a thickness of the green active layer 23, usually by adjusting a quantity of repeating pairs of quantum wells, such that different combinations of blue and green intensities can be achieved. As shown in FIG. 3, a schematic diagram of relative intensity comparison between blue light intensity 60 and green light intensity 70 of different quantum well repeating pairs. Taking quantities of repeating pairs of quantum well of 10, 25 and 40 as examples, it can be seen that if the quantity of repeating pairs of quantum well of the green active layer 23 is ten, the blue light intensity 60 is greater than the green light intensity 70; and if a quantity of repeating pairs of quantum well of the green active layer 23 is forty, the blue light intensity 60 is smaller than the green light intensity 70. As shown in FIG. 3, since quantity of pairs is directly proportional to thickness, by controlling a quantity of repeating pairs of quantum well of the green active layer 23, a ratio of the blue light converted into the green light can be controlled. In a similar way, by controlling a thickness of the red active layer 33, namely controlling a quantity of repeating pairs of quantum well, ratios of the blue light and the green light converted into the red light can be controlled. Therefore, the present invention is capable of controlling relative intensities of the three primary colors within green, blue, and red by adjusting thicknesses of the green active layer 23 and the red active layer 33. After controlling the relative intensities of the three primary colors within green, blue and red, as shown in FIG. 4, the blue light intensity 60, the green light intensity 70 and red light intensity 80 approaches the same, thereby meeting the requirements for backlight of thin-film transistor liquid crystal display (TFT-LCD).

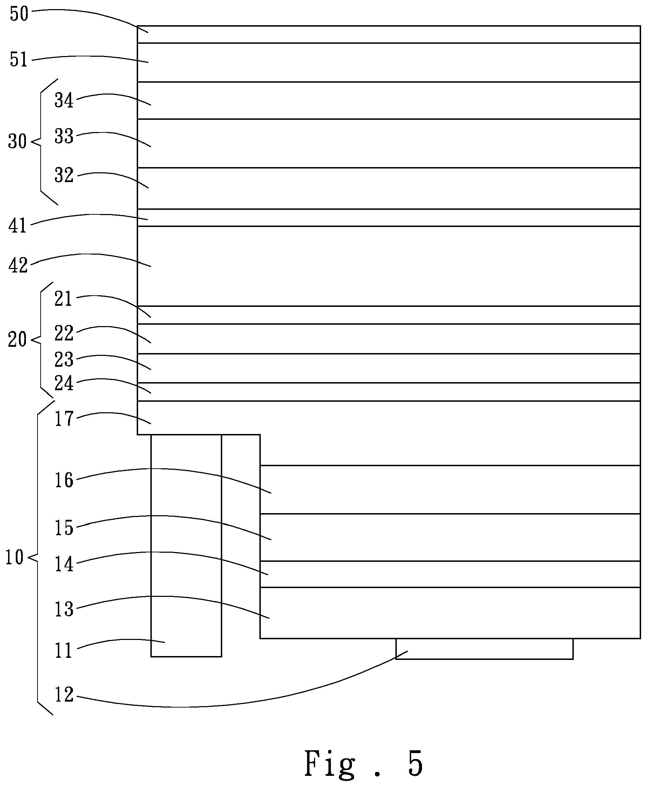

Please refer to FIG. 5 for a second embodiment of the present invention. In this embodiment, the electron-stimulated blue light-emitting structure 10, the light-stimulated green light-emitting structure 20, and the light-stimulated red light-emitting structure 30 are also included. Differences from the first embodiment are that this embodiment utilizes substances capable of connecting the sapphire material with the nitride semiconductor confinement layer material to make a connecting bonding layer 41. The connecting bonding layer 41 fixes the light-stimulated red light-emitting structure 30 and the light-stimulated green light-emitting structure 20 the electron-stimulated blue light-emitting structure 10. The light-stimulated green light-emitting structure 20 is formed on a sapphire wafer 42, and the connecting bonding layer 41 connects and fixes the light-stimulated red light-emitting structure 30 and the sapphire wafer 42.

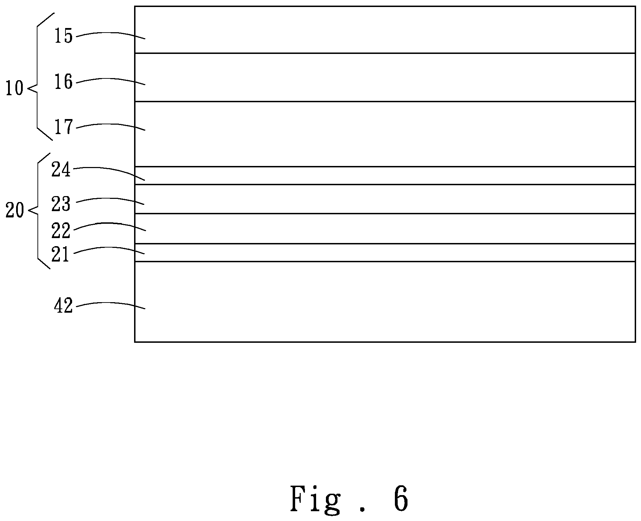

Steps of the manufacturing method of the second embodiment of the present invention are described as follows. First, as shown in FIG. 6, the buffer layer 21, the first confinement layer 22, the green active layer 23 and the second confinement layer 24 of the light-stimulated green light-emitting structure 20, and the N-type semiconductor layer 17, the blue active layer 16 and the P-type semiconductor layer 15 of the electron-stimulated blue light-emitting structure 10 are sequentially formed on one side of the sapphire wafer 42.

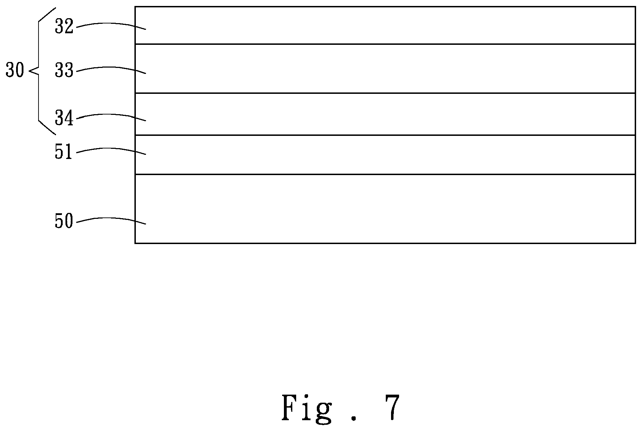

Then, as shown in FIG. 7, the light-stimulated red light-emitting structure 30 is formed on a wafer 50 for growing nitrides. A material of the wafer 50 is selected from any one of single crystal sapphire, single crystal silicon carbides (SiC) and single crystal gallium nitrides (GaN). In practice, a buffer layer 51 is formed on the wafer 50 first, and then the second confinement layer 34, the red active layer 33 and the first confinement layer 32 of the light-stimulated red light-emitting structure 30 are sequentially formed on the buffer layer 51.

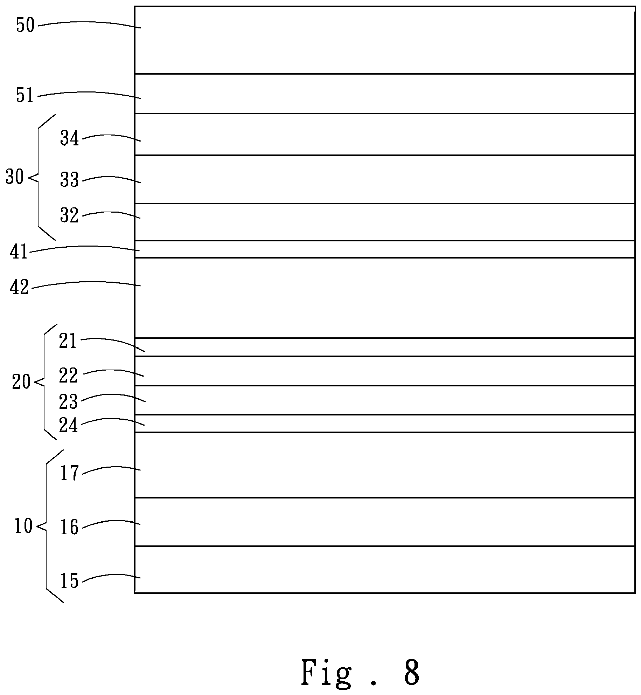

As shown in FIG. 8, it shows that the first confinement layer 32 of the light-stimulated red light-emitting structure 30 and the sapphire wafer 42 are connected and fixed by the connecting bonding layer 41; namely, the structures of FIG. 6 and FIG. 7 are connected and fixed by the connecting bonding layer 41. In order to connecting the sapphire wafer 42 and the first confinement layer 32 of the light-stimulated red light-emitting structure 30 by the connecting bonding layer 41, the connecting bonding layer 41 needs to be a stable structure and with high-temperature resistance (less than 300°C) to facilitate subsequent processes. Connection method of the connecting bonding layer 41 is selected from (a) to be connected with a transparent high-temperature resistant polymer, such as silicone, epoxy, etc.; (b) to be connected by spin-on glass (SOG) with liquid SiO₂; and (c) to be pressed and connected with transparent oxides, such as SiO₂, SiN, at high temperature and high pressure. Among them, connection with polymer is the simplest and the method of pressing and connecting with oxides at high temperature provides the best structure and transparency.

Then, the wafer 50 is removed, and the wafer 50 is removed by any process of grinding and thinning and laser separation. The reflective layer 14, the metal layer 13, the P-type electrode 12 and the N-type electrode 11 of the electron-stimulated blue light-emitting structure 10 is completed in subsequent manufacturing processes, that is, forming the structures shown in FIG. 5. Wherein, if grinding and thinning are used, most of the wafer 50 is removed; and laser separation is selected to completely remove the wafer 50.

In summary, the present invention at least includes following advantages:
1. The present invention uses the electron-stimulated light to generate the blue light, and then uses the light-stimulated light to generate the green light and the red light, so that the color rendering quality of the trichromatic spectrum is achieved.
2. Each of the layers of materials is composed of solid-state semiconductor materials, without the problems of light decay and poor reliability of phosphor to be capable of meeting the requirements for conditions of high temperature, low temperature and long-term vibration. Thus the present invention is suitable for applying in light-emitting components in the automotive industry.
3. The thicknesses of the blue active layer of the electron-stimulated blue light-emitting structure, the light-stimulated green light-emitting structure, and the red active layer of the light-stimulated red light-emitting structure can be adjusted, so as to achieve the control of an intensity of the trichromatic spectrum to provide a light source for a backlight of TFT-LCD. Since the half-height width of the trichromatic spectrum is relatively narrow, when using with a suitable color-filter, luminous efficiency can be effectively improved, which is suitable for high-brightness operation with low heat generation, and therefore performance of automotive display under sunlight can be enhanced.
4. Compared with the red light LED grown with gallium nitrides which grown with gallium nitrides is the electron-stimulated light structure, while the present invention is the grown light-stimulated red light-emitting structure. The red light nitride semiconductor structure grown with light-stimulated light is only required to consider the characteristics of light-stimulated light, and does not require to grow more complicated PN junction and to conductively doped with the semiconductor, so it is easier to grow nitrides of good single crystal quality with epitaxy to be used as the red active layer, and its light-stimulated light structure is capable of achieving better luminous efficiency.
5. The process is a wafer-level manufacturing procedure: the trichromatic structure is achieved through the wafer semiconductor process. In addition to being favorable for mass production, it can also be used for the production of any chip size, it is easy to manufacture extremely small sized trichromatic chips, and in the case of extremely small sized chip (<100um), there is no technical problem of coating phosphor due to the similar size of phosphor particles (particle size is approximately 10um).

## Claims

1. A flip-chip light-emitting diode structure capable of emitting trichromatic spectrum, comprising:
a blue-green light layer, the blue-green light layer comprising an electron-stimulated blue light-emitting structure (10) grown with nitride epitaxy, and a light-stimulated green light-emitting structure (20) grown with nitride epitaxy, the light-stimulated green light-emitting structure (20) disposed on the electron-stimulated blue light-emitting structure (10), the electron-stimulated blue light-emitting structure (10) stimulated by an externally applied voltage to generate a blue light, and the blue light stimulating the light-stimulated green light-emitting structure (20) to generate a green light;
a red light layer, the red light layer comprising a light-stimulated red light-emitting structure (30) grown with nitride epitaxy, and the blue light and the green light stimulating the light-stimulated red light-emitting structure (30) to generate a red light; and
a bonding layer, the bonding layer located between the light-stimulated red light-emitting structure (30) and the light-stimulated green light-emitting structure (20), and the bonding layer bonding and fixing the light-stimulated red light-emitting structure (30) and the light-stimulated green light-emitting structure (20).

2. The light-emitting diode structure as claimed in claim 1, wherein the bonding layer is a sapphire bonding layer (40), and the light-stimulated green light-emitting structure (20) and the light-stimulated red light-emitting structure (30) are respectively formed on two sides of the sapphire bonding layer (40) by growing epitaxy.

3. The light-emitting diode structure as claimed in claim 1 or 2, wherein the bonding layer is a connecting bonding layer, the connecting bonding layer connects and fixes the light-stimulated red light-emitting structure (30) and the light-stimulated green light-emitting structure (20), the light-stimulated green light-emitting structure (20) is formed on a sapphire wafer, and the connecting bonding layer binds and fixes the light-stimulated red light-emitting structure (30) and the sapphire wafer (42).

4. The light-emitting diode structure as claimed in any of the preceding claims, wherein the electron-stimulated blue light-emitting structure (10) is selectively made of aluminum indium gallium nitrides, and the electron-stimulated blue light-emitting structure (10) comprises an N-type semiconductor layer (17), a blue active layer (16) and a P-type semiconductor layer (15) stacked in sequence.

5. The light-emitting diode structure as claimed in any of the preceding claims, wherein the light-stimulated green light-emitting structure (20) is selectively made of aluminum indium gallium nitrides, and the light-stimulated green light-emitting structure (20) comprises a first confinement layer (22), a green active layer (23) and a second confinement layer (24) stacked in sequence.

6. The light-emitting diode structure as claimed in in any of the preceding claims, wherein the light-stimulated red light-emitting structure (30) is selectively made of aluminum indium gallium nitrides, and the light-stimulated red light-emitting structure (30) comprises a first confinement layer (31), a red active layer (33) and a second confinement layer (34) stacked in sequence.

7. A method of manufacturing a flip-chip light-emitting diode structure capable of emitting trichromatic spectrum, comprising steps of:
preparing a sapphire bonding layer (40) for growing epitaxy on two sides;
sequentially forming a first confinement layer (22), a green active layer (23) and a second confinement layer (24) of a light-stimulated green light-emitting structure (20), and an N-type semiconductor layer (17), a blue active layer (16) and a P-type semiconductor layer (15) of an electron-stimulated blue light-emitting structure (10) on one side of the sapphire bonding layer (40); and
sequentially forming a first confinement layer (32), a red active layer (33) and a second confinement layer (34) of a light-stimulated red light-emitting structure (30) on the other side of the sapphire bonding layer (40).

8. The method as claimed in claim 7, wherein a blue light generated by the electron-stimulated blue light-emitting structure (10) stimulated by an externally applied voltage is a main light source, and thicknesses of the green active layer (23) and the red active layer (33) are adjusted to control relative intensities of three primary colors.

9. A method of manufacturing a flip-chip light-emitting diode structure capable of emitting trichromatic spectrum, comprising steps of:
sequentially forming a first confinement layer (22), a green active layer (23) and a second confinement layer (24) of a light-stimulated green light-emitting structure (20), and an N-type semiconductor layer (17), a blue active layer (16) and a P-type semiconductor layer (15) of an electron-stimulated blue light-emitting structure (10) on one side of a sapphire wafer (42);
sequentially forming a second confinement layer (34), a red active layer (33) and a first confinement layer (32) of a light-stimulated red light-emitting structure (30) on a wafer for growing nitrides;
connecting and fixing the first confinement layer (32) of the light-stimulated red light-emitting structure (30) and the sapphire wafer (42) with a bonding layer; and
removing or thinning the wafer.

10. The method as claimed in claim 9, wherein a blue light generated by the electron-stimulated blue light-emitting structure (10) stimulated by an externally applied voltage is a main light source, and thicknesses of the green active layer (23) and the red active layer (33) are adjusted to control relative intensities of three primary colors.

11. The method as claimed in claim 9 or 10, wherein a method of connecting and fixing the connecting bonding layer with the light-stimulated red light-emitting structure (30) and the sapphire wafer (42) is selected from a group consisting of connecting with a transparent high-temperature resistant polymer, pressing and connecting with transparent oxides at high temperature and high pressure, and connecting by spin-on glass (SOG).

12. The method as claimed in any of claims 9 to 11, wherein a material of the wafer is selected from a group consisting of single crystal sapphire, single crystal silicon carbides and single crystal gallium nitrides.

13. The method as claimed in any of claims 9 to 12, wherein the wafer is removed by a process selected from a group consisting of grinding to thinning, and laser separation.
